# EUROPEAN PATENT APPLICATION

(11) **EP 4 675 601 A1**
(43) Date of publication of application: **07.01.2026**
(21) Application number: 23961245.0
(22) Date of filing: 20.12.2023
(51) Int. Cl.: G09G 3/3208, H10K 59/131, H10K 59/12

(54) **DISPLAY PANEL AND DISPLAY DEVICE**

(30) Priority: 14.12.2023 CN 202311725624
(71) Applicant: Wuhan China Star Optoelectronics Semiconductor Display Technology Co., Ltd., Wuhan, Hubei 430070 (CN)
(72) Inventor: LI, Fangjie, Wuhan, Hubei 430079 (CN); ZHANG, Huanxi, Wuhan, Hubei 430079 (CN)
(74) Representative: Stöckeler, Ferdinand
(86) International application number: PCT/CN2023/140071
(87) International publication number: WO 2025/123389

(57) **Abstract**

The present application provides display panels and display devices. In the display panel, the through holes are designed, so that when the position of the through holes is offset, an overlapping area of any clock signal line and the through holes remains unchanged, and the overlapping area of each clock signal line and the through holes is the same, so that the parasitic capacitance of each clock signal line is similar or even equal, avoiding different signal delays of adjacent clock signal lines, and avoiding signal delay changes caused by impedance changes of the clock signal lines, so that the display panel can display normally.

## Description

### TECHNICAL FIELD

The present application relates to the field of display technologies, and in particular, to display panels and display devices.

### BACKGROUND

Organic light-emitting diode (OLED) display devices are widely used due to their advantages such as self-illumination, wide color gamut, low power consumption, and flexible display capabilities. OLED display devices use the gate driver on array (GOA) technology to narrow the frame, and in order to release water vapor in an organic layer in the GOA area and reduce an impact of water vapor on electrical performance of elements in the GOA area, the existing OLED display devices are designed to trench large chunks of a metal above the organic layer. Specifically, the existing OLED display device digs groove in the metal of an anode layer above clock signal lines, so that one groove is located above a first clock line and a second clock line, another groove is located above a third clock line and a fourth clock line, and an area of the grooves above each clock line is equal. However, in an actual preparation process, due to a problem of mask alignment deviation during the trenching process of the anode layer, the grooves are offset relative to the clock lines, which in turn leads to different areas of different clock lines overlapping the grooves, thereby causing parasitic capacitances between different clock lines and the metal of the anode layer to change, and the changed parasitic capacitances change a total impedance of the clock line which cause a signal delay of the clock line, and changing trends of the the parasitic capacitances of adjacent clock lines are opposite, resulting in increasing signal delay difference between different clock lines, which affects signal output.

Therefore, the existing OLED display devices have a technical problem that the grooves above the clock lines are offset, causing excessive changes in the parasitic capacitances of the clock lines, which affects the display.

### SUMMARY

Embodiments of the present application provide a display panel and a display device to improve the technical problem in the existing OLED display devices that the grooves above the clock lines are offset, causing excessive changes in the parasitic capacitances of the clock lines, which affects the display.

In order to solve the above problems, technical solutions provided by the present application are as follows:

Embodiments of the present application provide a display panel, which includes a display area and a driving circuit area disposed on at least one side of the display area. The display panel includes:
a plurality of clock signal lines, disposed in the driving circuit area and each extending along a first direction;
a low-potential signal line, disposed in the driving circuit area, where an orthographic projection of the plurality of the clock signal lines on the low-potential signal line is located within the low-potential signal line;
the low-potential signal line is provided with a plurality of through holes arranged in an array to define a plurality of repeating units; in each of the repeating units, a number of the through holes in each column is the same; for any two of the clock signal lines, an overlapping area of one of the clock signal lines and all corresponding ones of the through holes in one of the repeating units is equal to an overlapping area of the other one of the clock signal lines and all corresponding ones of the through holes in one of the repeating units, and an overlapping area of any one of the clock signal lines and corresponding ones of the through holes in one of the repeating units is equal to a product of a width of one of the clock signal lines in a second direction, a length of one of the through holes in the first direction, and a number of the through holes in one column in one of the repeating units; and an angle between the first direction and the second direction is greater than 0 and less than or equal to 90 degrees.

At the same time, embodiments of the present application provide a display device, which includes the display panel as described in any one of the above embodiments.

### DESCRIPTION OF DRAWINGS

The technical solutions and other beneficial effects of the present application will be apparent through a detailed description of the specific embodiments of the present application in conjunction with the accompanying drawings.
FIG. 1 shows schematic diagrams illustrating that clock lines and grooves of a low-potential power signal line of an existing display device are not offset.
FIG. 2 shows schematic diagrams illustrating that the clock lines and the grooves of the low-potential power signal line in FIG. 1 are offset.
FIG. 3 shows bar graphs illustrating offsets between the clock lines and the grooves of the low-potential power signal line in FIG. 1 and variations of parasitic capacitances of the clock signal lines.
FIG. 4 is a first schematic diagram of a display panel provided by an embodiment of the present application.
FIG. 5 is a second schematic diagram of a display panel provided by an embodiment of the present application.
FIG. 6 is a third schematic diagram of a display panel provided by an embodiment of the present application.
FIG. 7 is a fourth schematic diagram of a display panel provided by an embodiment of the present application.
FIG. 8 shows first schematic diagrams illustrating that clock signal lines and through holes of a low-potential signal line are not offset according to an embodiment of the present application.
FIG. 9 shows schematic diagrams illustrating that the clock signal lines and the through holes of the low-potential signal line in FIG. 8 are offset.
FIG. 10 shows bar graphs illustrating offsets between the clock signal lines and the through holes of the low-potential signal line in FIG. 8 and variations of parasitic capacitances of the clock signal lines.
FIG. 11 shows second schematic diagrams illustrating that clock signal lines and through holes of a low-potential signal line are not offset according to an embodiment of the present application.
FIG. 12 shows schematic diagrams illustrating that the clock signal lines and the through holes of the low-potential signal line in FIG. 11 are offset.
FIG. 13 shows bar graphs illustrating offsets between the clock signal lines and the through holes of the low-potential signal line in FIG. 11 and variations of parasitic capacitances of the clock signal lines.

### EMBODIMENTS OF THE INVENTION

The technical solutions in the embodiments of the present application will be clearly and completely described below with reference to the accompanying drawings in the embodiments of the present application. Obviously, the described embodiments are only some of the embodiments of the present application, but not all of the embodiments. Based on the embodiments in the present application, all other embodiments obtained by those skilled in the art without making creative efforts fall within the protection scope of the present application.

In the description of the present application, it needs to be understood that orientations or positional relationships indicated by the terms "center", "longitudinal", "transverse", "length", "width", "thickness", "upper", "lower", "front", ", "rear", "left", "right", "vertical", "horizontal", "top", "bottom", "inside", "outside", "clockwise", "counterclockwise" etc. are based on the orientations or positional relationships shown in the drawings, which is only for the convenience of describing the present application and simplifying the description, and does not indicate or imply that the device or element referred to must have a specific orientation, be constructed and operated in a specific orientation, thus it cannot be construed as a limitation on the present application. In addition, the terms "first" and "second" are used for descriptive purposes only and cannot be understood as indicating or implying relative importance or implicitly indicating the quantity of indicated technical features. Thus, features defined as "first" and "second" may explicitly or implicitly include one or more of the described features. In the description of the present application, "plurality" means two or more than two, unless otherwise explicitly and specifically limited.

In the description of the present application, it should be noted that, unless otherwise clearly stated and limited, the terms "install", "link", and "connect" should be broadly understood, for example, it may be fixedly connected, detachably connected, or integrally connected; it may be mechanically connected, electrically connected, or communicated with each other; it may a direct connection or an indirect connection through an intermediary; it may be an internal connection between two elements or an interaction between two elements. For those of ordinary skill in the art, the specific meanings of the above terms in the present application can be understood according to specific circumstances.

In the present application, unless otherwise explicitly stated and limited, that a first feature is "above" or "below" a second feature may include direct contact between the first and second features, or may also include the first and second features not in direct contact but through additional characteristic contact between them. Furthermore, that a first feature is "over", "above" and "on" a second feature may include the first feature being directly above and diagonally above the second feature, or may simply mean that the first feature is higher in level than the second feature. That a first feature is "below" and "under" a second feature may include the first feature being directly below and diagonally below the second feature, or may simply mean that the first feature is less horizontally than the second feature.

The following disclosure provides many different embodiments or examples for implementing various structures of the present application. To simplify the disclosure of the present application, the components and arrangements of specific examples are described below. Of course, they are merely examples and are not intended to limit the invention. Furthermore, the present application may repeat reference numbers and/or reference letters in different examples, such repetition being for the purposes of simplicity and clarity and does not by itself indicate a relationship between the various embodiments and/or arrangements discussed. In addition, the present application provides examples of various specific processes and materials, but one of ordinary skill in the art will recognize the application of other processes and/or the use of other materials.

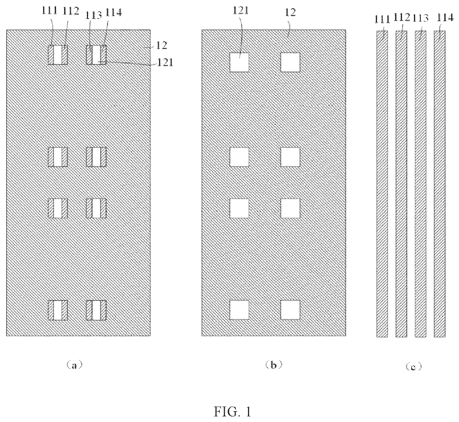

As illustrated in FIG. 1, (a) of FIG. 1 is a laminated diagram of a low-potential power signal line and clock lines, (b) of FIG. 1 is an exploded view of the low-potential power signal line in (a) of FIG. 1, and (c) of FIG. 1 is an exploded view of the clock lines in (a) of FIG. 1. As can be seen from FIG. 1, in order to release water vapor in an organic layer in a gate driving circuit area of the existing OLED display device, grooves are dug in the low-potential power signal line 12 of an anode layer in an area corresponding to the clock lines. Specifically, as illustrated in FIG. 1, in theory, one column of grooves 121 are located above a first clock line 111 and a second clock line 112, and another column of groove 121 are located above a third clock line 113 and a fourth clock line 114. However, in an actual preparation process, due to the problem of alignment deviation between a mask and the anode layer, the grooves may be offset.

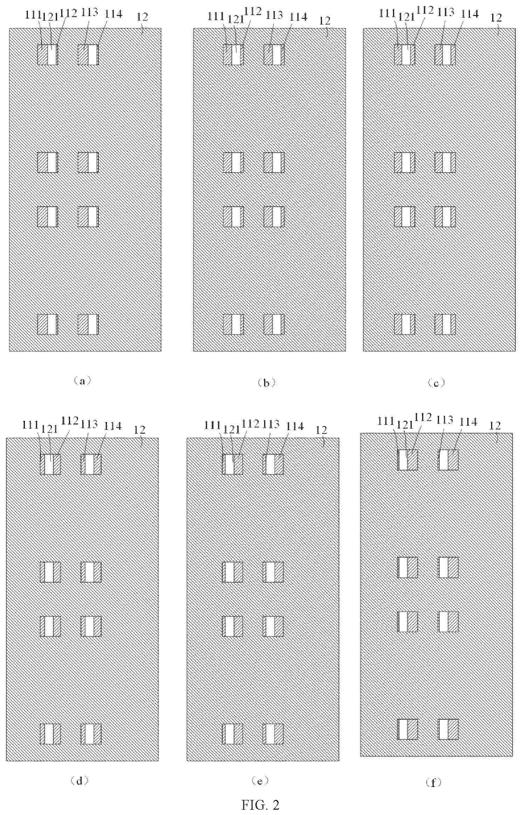

As illustrated in FIG. 2, (a) of FIG. 2 is a schematic diagram of an OLED display device when the grooves are offset to the left by 3 microns, and (b) of FIG. 2 is a schematic diagram of the OLED display device when the grooves are offset to the left by 2 microns, (c) of FIG. 2 is a schematic diagram of the OLED display device when the grooves are offset to the left by 1 micron, (d) in FIG. 2 is a schematic diagram of the OLED display device when the grooves are offset to the right by 1 micron, (e) in FIG. 2 is a schematic diagram of the OLED display device when the the grooves are offset to the right by 2 microns, and (f) in FIG. 2 is a schematic diagram of the OLED display device when the grooves are offset to the right by 3 microns. It can be seen from FIG. 2, when the grooves are offset, areas of two adjacent clock lines overlapping the grooves change, and the areas of the two adjacent clock lines overlapping the grooves are different, resulting in changes in parasitic capacitances between the clock lines and the low-potential power signal line.

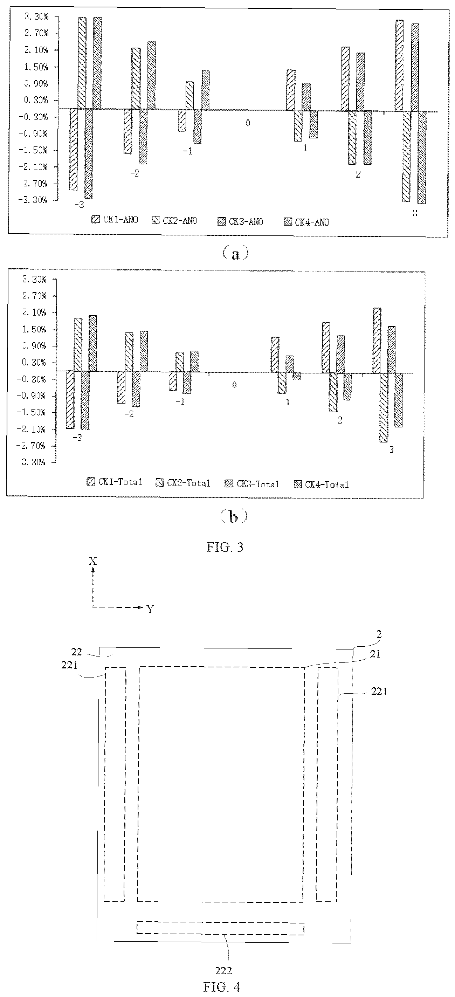

As illustrated in FIG. 3, "-3" on the abscissa of (a) of FIG. 3 means that the grooves are offset to the left by 3 microns, and "3" means that the grooves are offset to the right by 3 microns. Similarly, other values and values in (b) of FIG. 3 may refer to the above description. (a) of FIG. 3 illustrates variations of the parasitic capacitance between each clock line and the low-potential power signal line at different offsets. The abscissa in (a) of FIG. 3 represents the offset between the clock lines and the grooves of the low-potential power signal line, and the ordinate represents the variation of the parasitic capacitance between the clock line and the low-potential power signal line compared with the time when the clock lines and the grooves of the low-potential power signal line are not offset. The bar graphs in FIG. 3 illustrate the variations of the parasitic capacitances between different clock lines and the low-potential power signal lines. CK1-ANO represents the variation of the parasitic capacitance between the first clock line and the low-potential power signal line. CK2-ANO represents the variation of the parasitic capacitance between the second clock line and the low-potential power signal line. CK3-ANO represents the variation of the parasitic capacitance between the third clock line and the low-potential power signal line. CK4-ANO represents the variation of the parasitic capacitance between the fourth clock line and the low-potential power signal line. (b) of FIG. 3 shows variations of a parasitic capacitance between each clock line and all signal lines at different offsets. The abscissa in (b) of FIG. 3 represents the offset between the clock lines and the grooves of the low-potential power signal line, and the ordinate represents the variation of the parasitic capacitance between the clock line and all signal lines compared with the time when the clock lines and the grooves of the low-potential power signal line are not offset. The bar graphs in FIG. 3 illustrate the variations of the parasitic capacitances between different clock lines and all signal lines. CK1-Total represents the variation of the parasitic capacitance between the first clock line and all signal lines, CK2-Total represents the variation of the parasitic capacitance between the second clock line and all signal lines, CK3 -Total represents the variation of the parasitic capacitance between the third clock line and all signal lines, and CK4-Total represents the variation of the parasitic capacitance between the fourth clock line and all signal lines.

As can be seen from FIG. 2 and FIG. 3, compared with the time when the clock lines and the grooves of the low-potential power signal line are not offset, when the alignment of the low-potential power signal line and the mask deviates, which causes the grooves of the low-potential power signal line to offset relative to the clock lines, the parasitic capacitance between each clock line and the low-potential power signal line changes, and the parasitic capacitances between the adjacent clock lines and the low-potential power signal line are changed in opposite trends. For example, a changing trend of the parasitic capacitance between the first clock line 111 and the low-voltage power signal line 12 and a changing trend of the parasitic capacitance between the second clock line 112 and the low-voltage power signal line 12 are opposite, resulting in an increase in the signal delay difference between different clock lines. It can be understood that because the parasitic capacitances between the clock lines and the low-voltage power signal line change, causing electrical signals output by the clock lines to be inconsistent with preset electrical signals, and the signal delay difference between different clock lines increases, resulting in different operation times or different operation voltages of different transistors, which may affect the display effect. Therefore, the existing OLED display devices have the technical problem that the grooves above the clock lines are offset, causing excessive changes in the parasitic capacitances of the clock lines, which affects the display.

In view of the above technical problems, embodiments of the present application provide display panels and display devices to improve the above technical problems.

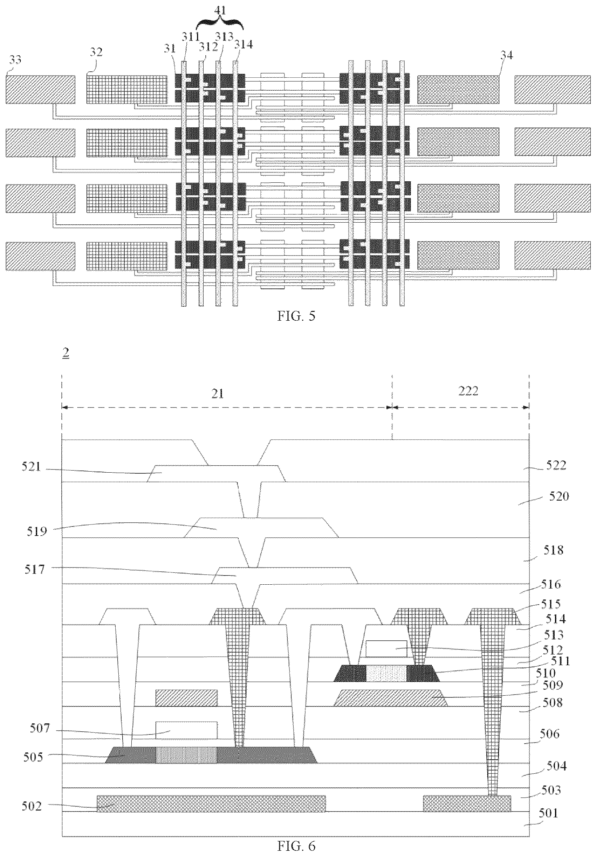

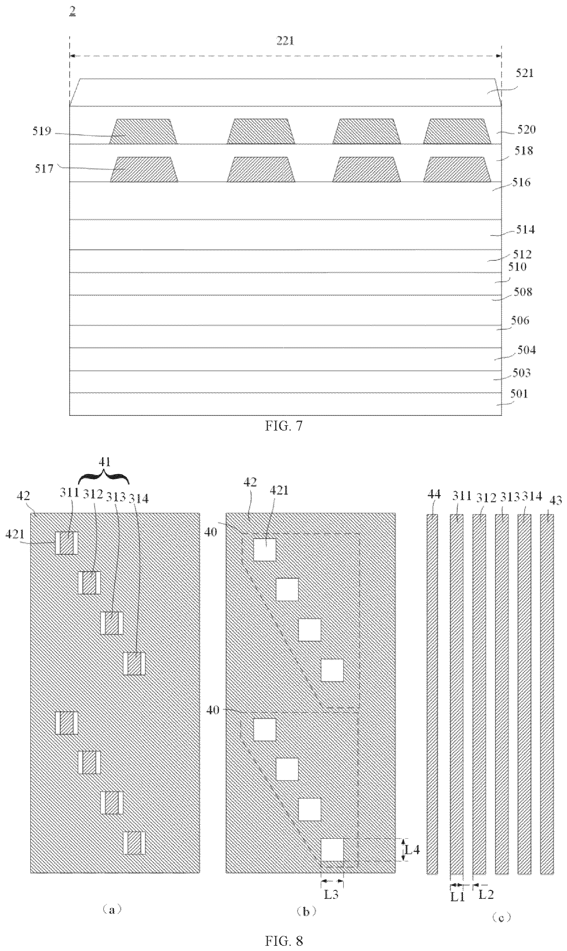

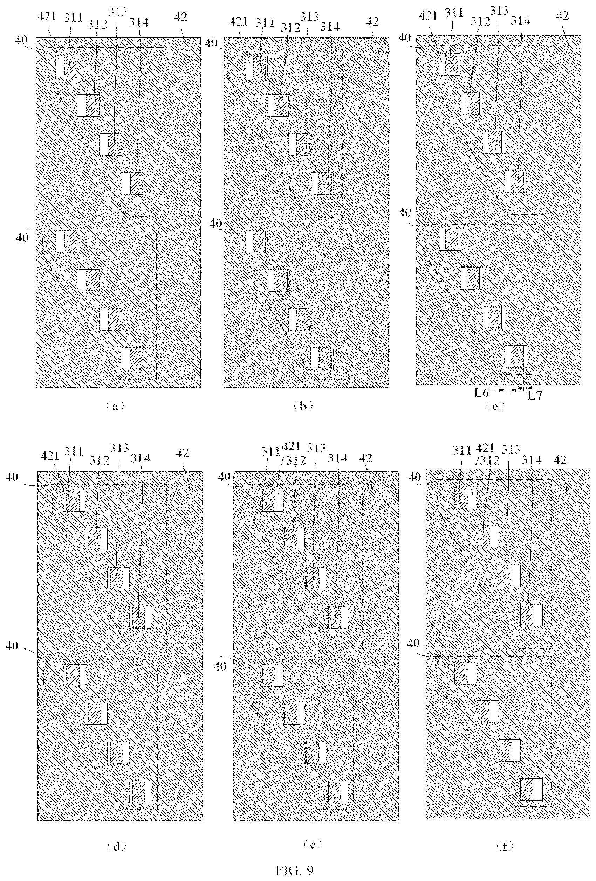

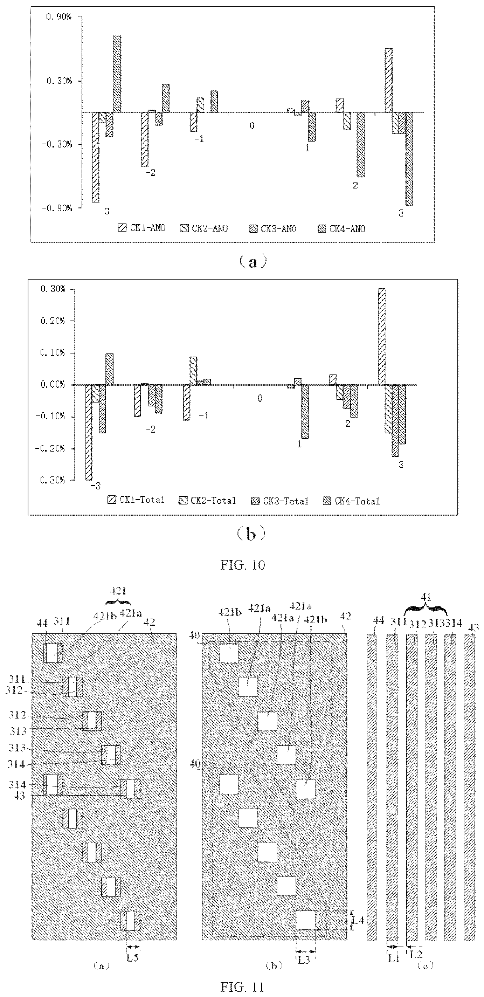

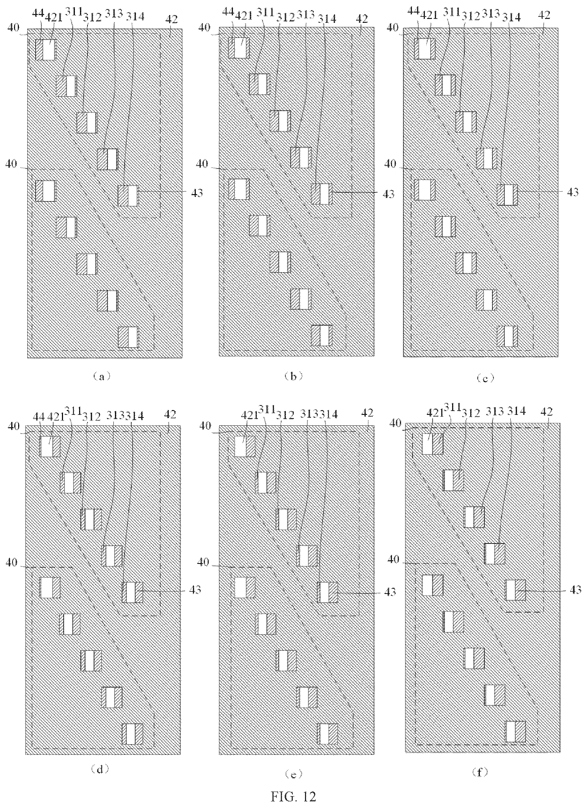

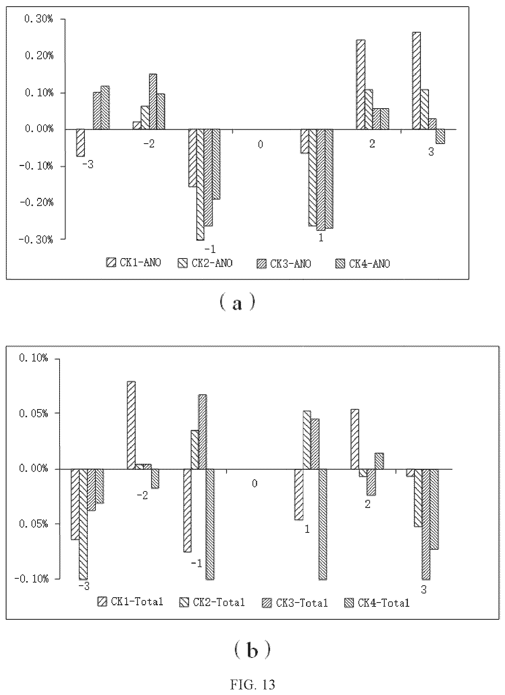

FIG. 4 is a first schematic diagram of a display panel provided by an embodiment of the present application. FIG. 5 is a second schematic diagram of a display panel provided by an embodiment of the present application. FIG. 6 is a third schematic diagram of a display panel provided by an embodiment of the present application. FIG. 7 is a fourth schematic diagram of a display panel provided by an embodiment of the present application. FIG. 8 shows first schematic diagrams illustrating that clock signal lines and through holes of a low-potential signal line are not offset according to an embodiment of the present application. FIG. 9 shows schematic diagrams illustrating that the clock signal lines and the through holes of the low-potential signal line in FIG. 8 are offset. FIG. 10 shows bar graphs illustrating offsets between the clock signal lines and the through holes of the low-potential signal line in FIG. 8 and variations of parasitic capacitances of the clock signal lines. FIG. 11 shows second schematic diagrams illustrating that clock signal lines and through holes of a low-potential signal line are not offset according to an embodiment of the present application. FIG. 12 shows schematic diagrams illustrating that the clock signal lines and the through holes of the low-potential signal line in FIG. 11 are offset. FIG. 13 shows bar graphs illustrating offsets between the clock signal lines and the through holes of the low-potential signal line in FIG. 11 and variations of parasitic capacitances of the clock signal lines.

As illustrated in FIG. 4 to FIG. 13, embodiments of the present application provide display panels 2. The display panel 2 includes a display area 21 and a driving circuit area 221 disposed on at least one side of the display area 21, and the display panel 2 includes:
a plurality of clock signal lines 41, disposed in the driving circuit area 221, and each extending along a first direction X; and
a low-potential signal line 42, disposed in the driving circuit area 221, and wherein an orthographic projection of the plurality of clock signal lines 41 on the low-potential signal line 42 is located within the low-potential signal line 42;
wherein the low-potential signal line 42 is provided with a plurality of through holes 421 arranged in an array to define a plurality of repeating units 40. In each repeating unit 40, a number of the through holes 421 in each column is the same (for example, in each repeating unit 40 in FIG. 8, the number of the through holes in each column is 1). For any two clock signal lines 41, an overlapping area of one clock signal line 41 and all corresponding through holes 421 in one repeating unit 40 is equal to an overlapping area of the other clock signal line 41 and all corresponding through holes 421 in one repeating unit 40 are equal (for example, in FIG. 8, an overlapping area of the first clock signal line 311 and all the corresponding through holes 421 in one repeating unit 40 is L4*L1*1, and an overlapping area of the second clock signal line 312 and all the corresponding through holes 421 in one repeating unit 40 is L4 *L1*1, the two are equal). The overlapping area of any clock signal line 41 and the corresponding through holes 421 in one repeating unit 40 is equal to a product of a width L1 of the clock signal line 41 in a second direction Y, a length L4 of the through hole 421 in the first direction, and a number of the through holes 421 in one column in one repeating unit 40 (for example, in FIG. 8, the overlapping area of the first clock signal line 311 and all the corresponding through holes 421 in one repeating unit 40 is L4*L1*1). An angle between the first direction X and the second direction Y is greater than 0 and less than or equal to 90 degrees.

Embodiments of the present application provide display panels. In the display panel, for any two clock signal lines, the overlapping area of one clock signal line and the all corresponding through holes in one repeating unit is equal to the overlapping area of the other clock signal line and the all corresponding through holes in one repeating unit are equal, and the overlapping area of any clock signal line and the corresponding through holes in one repeating unit is equal to the product of the width of the clock signal line in the second direction, the width of the through hole, and the number of the through holes in one column in one repeating unit, so that when a position of the through holes is offset, the overlapping area of any clock signal line and the through holes remains unchanged, and the overlapping area of each clock signal line and the through holes is equal, so that the parasitic capacitance of each clock signal line is similar or even equal, thereby avoiding different signal delays of adjacent clock signal lines, and preventing signal delay changes caused by impedance changes of the clock signal lines, so that the display panel can display normally.

Specifically, in the drawings of the present application, the number of the through holes in each column of the repeating unit 40 is 1, but the embodiments of the present application are not limited thereto. For example, the number of the through holes in each column of the repeating unit 40 may be 2.

Specifically, as illustrated in FIG. 4, the display panel 2 includes the display area 21 and a non-display area 22. The non-display area 22 includes the driving circuit area 221 and a bonding area 222. The driving circuit area 221 is provided with a gate driving circuit. As illustrated in FIG. 5, the gate driving circuit includes first scan driving units 31, second scan driving units 32, third scan driving units 34, and signal control units 33. The first scan driving units 31 and the signal control units 33 may be disposed in the driving circuit area 221 on both sides of the display area 21. The first scan driving units 31 include clock signal lines 41.

Specifically, the low-potential signal line 42 refers to a low-potential power signal line connected to a light-emitting element of the display panel. After being connected to a common electrode of the display panel, the low-potential signal line 42 is transferred through a pixel electrode layer 521 and then connected to signal lines of a second source and drain layer 517 to input signals (other parts of the low-potential signal line 42 are not shown in the figures). Therefore, in FIG. 7, the part of the pixel electrode layer 521 is the low-potential signal line 42, and the low-potential signal line 42 is not in contact with a pixel electrode in the pixel electrode layer 521.

Specifically, as illustrated in FIG. 5 and FIG. 8, the plurality of clock signal lines 41 include a first clock signal line 311, a second clock signal line 312, a third clock signal line 313, and a fourth clock signal line 314. A width of each clock signal line 41 is equal, and a distance between adjacent clock signal lines 41 is equal.

Specifically, as illustrated in FIG. 7, the clock signal lines 41 are wired in parallel through the second source and drain layer 517 and a third source and drain layer 519.

In some embodiments, the through holes in each column are arranged along the first direction, and the through holes in two adjacent rows are spaced in the first direction.

In some embodiments, a number of columns of the through holes is equal to a number of the clock signal lines, and each column of through holes is corresponding to one of the clock signal lines. The through hole is arranged symmetrically about a center axis of the clock signal line. A distance between an end of the through hole corresponding to one clock signal line close to another clock signal line and the another clock signal line is greater than or equal to a maximum offset of the through hole. A width of a portion of the through hole beyond the clock signal line is greater than or equal to the maximum offset of the through hole.

In some embodiments, the width of the through hole is equal to a sum of the width of the clock signal line and the distance between adjacent clock signal lines.

In some embodiments, the distance between adjacent clock signal lines is greater than a sum of the maximum offset of the through hole and half of the width of the portion of the through hole beyond the clock signal line.

In some embodiments, each column of through holes is arranged corresponding to one of the clock signal lines. In the repeating unit, minimum distances of two ends of each through hole from the corresponding clock signal line are not equal. For any two clock signal lines, the minimum distance between one end of each through hole and the corresponding clock signal line is equal, and the minimum distance between the other end of each through hole and the corresponding clock signal line is equal.

In some embodiments, each column of through holes is arranged corresponding to one of the clock signal lines. One end of each through hole corresponding to the clock signal line is aligned with an end of the clock signal line, and the other end of each through hole is aligned with an end of another clock signal line.

In some embodiments, a minimum distance between a left end of the through hole and the corresponding clock signal line is greater than a minimum distance between a right end of the through hole and the corresponding clock signal line; alternatively, the minimum distance between the left end of the through hole and the corresponding clock signal line is less than the minimum distance between the right end of the through hole and the corresponding clock signal line.

In some embodiments, the through holes include first through holes each corresponding to two adjacent clock signal lines and second through holes each corresponding to one clock signal line. Along the first direction, for two adjacent columns of through holes, one end of each through hole in one column close to the other column is located on the same straight line as one end of each through hole in the other column.

In some embodiments, the first through hole is disposed symmetrically about a center line of a portion of the low potential signal line between two adjacent clock signal lines, and a width of a portion of the second through hole beyond the clock signal line is greater than the maximum offset of the through hole.

In some embodiments, one end of the through hole corresponding to one clock signal line and the other end of the through hole corresponding to another clock signal line are respectively located on center lines of the two clock signal lines.

In some embodiments, for the first through holes and the second through holes corresponding to the same clock signal line, an overlapping area of one second through hole and the corresponding clock signal line is less than an overlapping area of one first through hole and the corresponding clock signal line, and an overlapping area of another second through hole and the corresponding clock signal line is greater than an overlapping area of another first through hole and the corresponding clock signal line, and areas of any first through hole overlapping two adjacent clock signal lines are not equal.

In some embodiments, the display panel includes two groups of symmetrically arranged first scan driving units, each group of first scan driving units includes four clock signal lines, and the through holes include two columns of second through holes and three columns of first through holes located between the two columns of second through holes.

In some embodiments, as illustrated in FIG. 8, the through holes 421 in each column are arranged along the first direction X, and the through holes 421 located in two adjacent rows are spaced in the first direction X. By alternating two adjacent columns of through holes up and down in the arrangement direction of the clock signal lines, the through holes above each clock signal line are distributed more evenly, which may release water vapor in each area and improve the performance of the display panel.

Specifically, (a) of FIG. 8 is a first laminated diagram of the clock signal line 41 and the low-potential signal line 42, and (b) of FIG. 8 is an exploded view of the low-potential signal line 42 in (a) of FIG. 8, and (c) of FIG. 8 is an exploded view of the clock signal line 41 in (a) of FIG. 8.

Specifically, it can be understood that FIG. 8 and FIG. 9 illustrate designs of different display panels during the actual preparation process.

Specifically, it can be seen that in two adjacent columns of through holes, in the arrangement direction of the clock signal lines, the through holes in one column are translated downward relative to the through holes in the other column, so that the through holes above each clock signal line are distributed more evenly to release the water vapor in each area and avoid water vapor intrusion causing change in the performance of the thin film transistors. However, the embodiments of the present application are not limited to this, and two adjacent columns of through holes may be in contact in the arrangement direction of the clock signal line.

In some embodiments, a left end of the leftmost through hole is disposed beyond the leftmost clock signal line, a right end of the rightmost through hole is disposed beyond the rightmost clock signal line, and half of a width of a portion of the through hole beyond the clock signal line is greater than the maximum offset of the through hole. By overlapping the through holes with each clock signal line, and making half of the width of the portion of the through hole beyond the clock signal line greater than the maximum offset of the through hole, when the position of the through holes is offset, the overlapping area of the through holes and any clock signal line is equal, so that the difference in parasitic capacitance between each clock signal line and the low-potential signal line changes little, and the parasitic capacitances between adjacent clock signal lines and the low-potential signal line are similar or even the same, which can avoid poor display caused by excessive changes in the parasitic capacitances between the clock signal lines and the low-potential signal line, and avoid excessive difference in the parasitic capacitances between different clock signal lines and the low-potential signal line, so as to further avoid poor display.

Specifically, as illustrated in FIG. 8, the left ends of the leftmost through holes 421 are disposed beyond the leftmost clock signal line (i.e. the first clock signal line 311 in FIG. 8), the right ends of the rightmost through holes 421 are disposed beyond the rightmost clock signal line (i.e. the second clock signal line 314 in FIG. 8), and half of the width of the portion of the through hole 421 beyond the clock signal line 41 is greater than the maximum offset of the through hole 421. Taking FIG. 8 as an example, half of the width of the portion of the through hole 421 beyond the clock signal line 41 is (L3-L1)/2, by making this value greater than the maximum offset of the through hole, the overlapping area of the through holes and any clock signal line can be equal.

Specifically, in the embodiments of the present application, the through holes in the non-offset state means that the through holes are in a theoretical design position, and there is no alignment shift between the mask and the pixel electrode layer. The through holes in the offset state means that the through holes are in a non-theoretical design position, and the alignment shift occurs between the mask and the pixel electrode layer, causing the position of the through holes to offset.

Specifically, the maximum offset of the through holes refers to a maximum lateral offset of the through holes relative to the design position during the actual preparation process. For example, during design, a center line of the through hole coincides with a center line of the clock signal line, but in the actual preparation process, the maximum offset of the center line of the through hole to the right relative to the center line of the clock signal line is 3 microns, considering that when the through hole is offset, the maximum offset to both sides is equal, then the maximum offset of the through hole is 3 microns; but when the offsets of the through hole to both sides are unequal, the offset that the through the hole is more offset to one side serves as the maximum offset of the through hole.

In some embodiments, as illustrated in FIG. 8, the number of columns of the through holes 421 is equal to the number of the clock signal lines 41, and each column of through holes 421 is arranged corresponding to one of the clock signal lines 41. The through hole 421 is arranged axially symmetrically about the center line of the clock signal line 41. The distance between the end of the through hole 421 corresponding to one clock signal line 41 close to another clock signal line 41 and the another clock signal line 41 is greater than or equal to the maximum offset of the through hole 421. The width (for example, (L3-L1)/2 in FIG. 8) of the portion on either side of the through hole 421 beyond the clock signal line 41 is greater than or equal to the maximum offset of the through hole 421.

Specifically, when designing relative positions of the through holes and the clock signal lines, the through holes may be in a non-offset state or in the actual product, the through hole may be symmetrical about the center line of the clock signal line, so that in the actual preparation process, even if the through holes are offset relative to the clock signal lines, because the width of the portion on either side of the through hole beyond the clock signal line is greater than or equal to the maximum offset of the through holes, and the distance between the end of the through hole close to another clock signal line and the another clock signal line is greater than or equal to the maximum offset of the through holes, the overlapping area of the clock signal line and the corresponding through holes does not change, so that the parasitic capacitance between the clock signal line and the low power supply signal line changes little or even does not change, the impedance of the clock signal line changes little or even does not change, and the difference in impedance change of any two clock signal lines is slight or even the same, so as to avoid the impedance difference of different clock signal lines causing poor display.

Specifically, as illustrated in FIG. 8, the number of columns of through holes 421 is 4, and the number of clock signal lines 41 is 4, which are equal, so that each column of through holes 421 is arranged corresponding to one of the clock signal lines 41. The through hole 421 is arranged symmetrically about the center line of the clock signal line 41, so that the widths of the two portions of the through hole 421 beyond the clock signal line 41 are equal, and the distance between each through hole 421 corresponding to one clock signal line 41 and the another clock signal line 41 is greater than or equal to the maximum offset of the through hole 421. For example, the distance between the through hole 421 corresponding to the first clock signal line 311 and the second clock signal line 312 is greater than the maximum offset of the through hole 421, which may prevent the through holes corresponding to the first clock signal line from being offset to the second clock signal line, so that the area of each clock signal line overlapping the through holes may be kept unchanged, and the width of the portion on either side of the through hole beyond the clock signal line 41 is greater than or equal to the maximum offset of the through hole 421. For example, the width of the portion on the right side of the through hole beyond the first clock signal line 311 in FIG. 8 is greater than the maximum offset of the through holes 421.

Specifically, each column of through holes is arranged corresponding to one of the clock signal lines, and when the through holes are in the non-offset state, the through hole is arranged symmetrically about the axis of the clock signal line, and the distance between the end of the through hole corresponding to one clock signal line close to another clock signal line and the another clock signal line is greater than or equal to the maximum offset of the through hole, and the width of the portion of the through hole beyond the clock signal line is greater than the maximum offset of the through hole, so that when the through holes are offset, the through holes will be not offset to another clock signal line, and the overlapping area of one single through hole and the corresponding clock signal line remains as the product of the length of the through hole and the width of the clock signal line, so that the overlapping area of the through hole and the clock signal line does not change, the parasitic capacitance between the clock signal line and the low power signal line changes little or even does not change, the impedance of the clock signal line changes little or even does not change, and the difference in impedance change of any two clock signal lines is slight or even the same, so as to avoid poor display caused by impedance differences of different clock signal lines.

Specifically, the above embodiments take that the through hole is arranged symmetrically about the center line of the clock signal line as an example, but the embodiments of the present application are not limited to this. For example, when the through holes are in a non-offset state, that is, in theoretical design or actual products, the through hole may not be arranged axially symmetrically about the center line of the clock signal line, but such that the distance between both ends of the through hole and another clock signal line is greater than or equal to the maximum offset of the through hole, and the width of the portion of the through hole beyond the corresponding clock signal line is greater than or equal to the maximum offset of the through hole, so that the through hole will be not offset to another clock signal line, and the overlapping area of the through hole and the corresponding clock signal line will not change.

For example, the leftmost through hole is not symmetrical about the center line of the first clock signal line 311, but the width of the portion on either side of the leftmost through hole beyond the first clock signal line 311 is greater than or equal to the maximum offset of the through hole, and the distance between either side of the through hole and another clock signal line is greater than or equal to the maximum offset of the through hole. For example, the width of the portion on the left side of the through hole beyond the first clock signal line 311 is 4, the width of the portion on the right side of the through hole beyond the first clock signal line 311 is 3, both of the two are greater than the maximum offset of the through hole, then the overlapping area of the first clock signal line and the through holes can be equal to the overlapping area of the another clock signal line and the through holes.

In some embodiments, as illustrated in FIG. 8, the width L3 of the through hole 421 is equal to the sum of the width L1 of the clock signal line 41 and the distance L2 between adjacent clock signal lines 41. By making the width of the through hole equal to the sum of the width of the clock signal line and the distance between adjacent clock signal lines, making the through hole arranged symmetrically about the clock signal line, and making the width of the through hole beyond the clock signal line greater than or equal to the maximum offset of the through hole, then the two portions of the through hole beyond the clock signal line are symmetrical about the clock signal line, and for two adjacent columns of through holes, the right ends of the through holes in one column are aligned with the left ends of the through holes in the other column, so that when the through holes are offset, regardless of whether they are offset to the left or right, the overlapping area of the clock signal line and the through holes can be kept unchanged, and the area of each clock signal line overlapping the through holes is close to or even equal, so that the impedance change of each clock signal line is small or even there is no change, and the difference in impedance change of any two clock signal lines is slight or even the same, so as to avoid poor display caused by impedance differences of different clock signal lines.

Specifically, assuming that the width of the clock signal line is 8 microns and the distance between adjacent clock signal lines is 6 microns, the width of the through hole is 14 microns and the length of the through hole is 14 microns, then the width of the portion of the through hole beyond one side of the clock signal line is 3 microns. Taking the maximum offset of the through holes as 3 microns as an example, no matter whether the through holes are offset to the left or the right, the overlapping area of one single through hole and the clock signal line remains 14 microns* 8 microns, and the overlapping area of each clock signal line and the through holes is the same. Therefore, the impedance of each clock signal line changes little (the reason for the change may be that the position of the through holes is offset, resulting in slight electrical differences in the signal lines causing the impedance change of the clock signal lines) or even does not change, so as to avoid the impedance change of the clock signal line causing poor display. And the difference in the impedance change of any two clock signal lines is slight or even the same, so as to avoid the impedance difference of different clock signal lines resulting in poor display.

In some embodiments, as illustrated in FIG. 8, the distance L2 between adjacent clock signal lines 41 is greater than the sum of the maximum offset of the through holes 421 and half of the width of the portion of the through hole beyond the clock signal line 41. By making the distance between adjacent clock signal lines greater than the sum of the maximum offset of the through holes and half of the width of the portion of the through hole beyond the clock signal line, even if the through holes are offset during the actual preparation process, the through holes will be not offset to the adjacent clock signal lines, and the width of the portion of the through hole beyond the clock signal line is greater than or equal to the maximum offset of the through hole, so that the overlapping area of the clock signal line and the through holes does not change, and the overlapping area of each clock signal line and the through holes is similar or even equal, so that the impedance of each clock signal line changes little or even does not change, and the difference in impedance change of any two clock signal lines is slight or even the same, so as to avoid impedance differences of the clock signal lines causing poor display.

Specifically, assuming that the distance between adjacent clock signal lines is 8 microns, the maximum offset of the through hole is 3 microns, and the width of the portion of the through hole beyond the clock signal line is 8 microns, then the distance between the adjacent clock signal lines is greater than the sum of the maximum offset of the through hole and half of the width of the portion of the through hole beyond the clock signal line. When the through holes are offset, the through holes will be not offset to other clock signal lines, and the overlapping area of the through holes and the clock signal line remains unchanged.

Specifically, the above embodiments take that the through hole is arranged axially symmetrically about the center line of the clock signal line as an example, but the embodiments of the present application are not limited thereto. For example, when the through holes are in the non-offset state, the width of the portion on either side of the through hole beyond the clock signal line is greater than or equal to the maximum offset of the through hole, and the distance between adjacent clock signal lines is greater than or equal to the sum of the maximum offset of the through hole and the maximum width of the portions of the through hole beyond the clock signal line. For example, the widths of the two portions of the through hole beyond the clock signal line are different, the width of one portion of the through hole beyond the clock signal line is 4 microns, and the width of the other portion of the through hole beyond the clock signal line is 3 microns, then the maximum width of the portions of the through hole beyond the clock signal line is 4 microns, and at the same time, the distance between adjacent clock signal lines is greater than or equal to the sum of the maximum offset of the through hole and the maximum width of the portions of the through hole beyond the clock signal line. For example, the distance between adjacent clock signal lines is 8 microns, and the maximum offset of the through hole is 3 microns, then the through hole will be not offset to another clock signal line, and the overlapping area of the through holes and the corresponding clock signal line will not change.

In some embodiments, as illustrated in FIG. 9, each column of through holes 421 is arranged in correspondence with one of the clock signal lines 41. In the repeating unit 40, minimum distances of both ends of the through hole 421 from the corresponding clock signal lines 41 are different, and corresponding to any two of the clock signal lines 41, the minimum distance between one end of each through hole 421 and the corresponding clock signal line 41 is equal, and the minimum distance between the other end of each through hole 421 and the corresponding clock signal line 41 is equal.

Specifically, during the actual preparation process, due to process deviation, the position of the through holes will deviate from the theoretical design position. At this time, the minimum distances between the two ends of the through hole and the corresponding clock signal line are not equal, but corresponding to any two clock signal lines, the minimum distance between one end of each through hole and the corresponding clock signal line is equal, and the minimum distance between the other end of each through hole and the corresponding clock signal line is equal, so that the offset of each through hole relative to the corresponding clock signal line is the same, and the overlapping area of each through hole and the corresponding clock signal line remains unchanged, and the overlapping area of each through hole and the corresponding clock signal line is equal, so that the parasitic capacitance between the clock signal line and the low power supply signal line changes little or even does not change, the impedance of the clock signal line changes little or even does not change, and the difference in impedance change of any two clock signal lines is slight or even the same, so as to avoid the impedance difference of different clock signal lines causing poor display.

Specifically, the minimum distances of the two ends of the through hole 421 from the corresponding clock signal line 41 refer that the through hole has left and right ends, and the distance L6 between the left end of the through hole and a left end of the corresponding clock signal line is the minimum distance between the left end of the through hole and the corresponding clock signal line, and the distance L7 between the right end of the through hole and a right end of the corresponding clock signal line is the minimum distance between the right end of the through hole and the corresponding clock signal line, then the distance between the left end of the through hole and the left end of the corresponding clock signal line and the distance between the right end of the through hole and the right end of the corresponding clock signal line are the minimum distances of the two ends of the through hole from the corresponding clock signal line.

Specifically, as illustrated in FIG. 9, it can be seen that the distance L6 between the left end of the through hole and the left end of the corresponding clock signal line and the distance L7 between the right end of the through hole and the right end of the corresponding clock signal line are not equal, but corresponding to any two of the clock signal lines 41, such as corresponding to the first clock signal line 311 and the second clock signal line 312, the distance between the left end of each through hole 421 corresponding to the first clock signal line 311 and the left end of the first clock signal line 311 is equal to the distance between the left end of each through hole 421 corresponding to the second clock signal line 312 and the left end of the second clock signal line 312, and the distance between the right end of each through hole 421 corresponding to the first clock signal line 311 and the right end of the first clock signal line 311 is equal to the distance between the the right end of the through hole 421 corresponding to the second clock signal line 312 and the right end of the second clock signal line 312, such that the offset of the through holes relative to the corresponding clock signal line is the same, and the overlapping area of each through hole and the corresponding clock signal line remains unchanged.

In some embodiments, as illustrated in (a) and (f) in FIG. 9, each column of through holes 421 are arranged in correspondence with one of the clock signal lines 41. Corresponding to the same clock signal line 41, one end of each through hole 421 is aligned with an end of the clock signal line 41, and the other end of each through hole 421 is aligned with an end of another clock signal line 41. By aligning one end of the through hole with the end of another clock signal line, the through hole is prevented from being offset to another clock signal line, so that the overlapping area of each clock signal line and the through holes remains unchanged, so that the impedance of the clock signal line changes little or even does not change, and the difference in impedance change of any two clock signal lines is slight or even the same, so as to avoid the impedance difference of different clock signal lines causing poor display.

In some embodiments, as illustrated in FIG. 9, when the through hole 421 is in the offset state, one end of the through hole 421 corresponding to one clock signal lines 41 is aligned with the end of another clock signal line 41. When the through hole is in the offset state, by aligning one end of the through hole with the end of another clock signal line, the through hole is prevented from being offset to another clock signal line, so that the overlapping area of each clock signal line and the through holes remains unchanged, so that the impedance of the clock signal line changes little or even does not change, and the difference in impedance change of any two clock signal lines is slight or even the same, so as to avoid the impedance difference of different clock signal lines causing poor display.

Specifically, taking the maximum offset of the through holes as 3 microns as an example, (a) of FIG. 9 illustrates an laminated diagram of the clock signal line and the low-potential signal line when the through holes in FIG. 8 are offset by 3 microns to the left relative to the clock signal line, (b) of FIG. 9 illustrates an laminated diagram of the clock signal line and the low-potential signal line when the through holes in FIG. 8 are offset by 2 microns to the left relative to the clock signal line, c) of FIG. 9 illustrates an laminated diagram of the clock signal line and the low-potential signal line when the through holes in FIG. 8 are offset by 1 micron to the left relative to the clock signal line, (d) of FIG. 9 illustrates an laminated diagram of the clock signal line and the low-potential signal line when the through holes in FIG. 8 are offset by 1 micron to the right relative to the clock signal line, (e) of FIG. 9 illustrates an laminated diagram of the clock signal line and the low-potential signal line when the through holes in FIG. 8 are offset by 2 microns to the right relative to the clock signal line, and (f) of FIG. 9 illustrates an laminated diagram of the clock signal line and the low-potential signal line when the through holes in FIG. 8 are offset by 3 microns to the right relative to the clock signal line.

As illustrated in (a) of FIG. 9, when the through hole 421 is in the offset state, the left end of the through hole 421 corresponding to the second clock signal line 312 is aligned with the right end of the first clock signal line 311, the left end of the through hole 421 corresponding to the third clock signal line 313 is aligned with the right end of the second clock signal line 312, and the left end of the through hole 421 corresponding to the fourth clock signal line 314 is aligned with the right end of the third clock signal line 313. As illustrated in (f) of FIG. 9, the right end of the through hole 421 corresponding to the first clock signal line 311 is aligned with the left end of the second clock signal line 312, and the right end of the through hole 421 corresponding to the second clock signal line 312 is aligned with the left ends of the third clock signal line 313, and the right end of the through hole 421 corresponding to the third clock signal line 313 is aligned with the left end of the fourth clock signal line 314.

Specifically, when the through hole is at its maximum offset, one end of the through hole is aligned with an end of another clock signal line, so that the through hole will be not offset to another clock signal line, which avoids the change in the overlapping area of the clock signal line and the through holes causing the impedance of the clock signal line to change, improving the display effect of the display panel.

In some embodiments, as illustrated in (a) to (c) of FIG. 9, the minimum distance L6 between the left end of the through hole 421 and the corresponding clock signal line 41 is greater than the minimum distance L7 between the right end of the through hole 421 and and the corresponding clock signal line 41; or as illustrated in (d) to (f) in FIG. 9, the minimum distance L6 between the left end of the through hole 421 and the corresponding clock signal line 41 is less than the minimum distance L7 between the right end of the through hole 421 and the corresponding clock signal line 41 (L7 in (a) of FIG. 9 is 0, and L6 in (f) of FIG. 9 is 0).

In some embodiments, as illustrated in FIG. 9, when the through holes 421 are in the offset state, the two ends of the through hole 421 corresponding to one of the clock signal lines 41 are spaced apart from another two clock signal lines 41 on both sides of the clock signal line 41, and the distance between the two ends of the through hole 421 and the another two clock signal lines 41 on both sides of the clock signal line 41 are not equal. By spacing the two ends of the through hole and another two clock signal lines on both sides of the clock signal line corresponding to the through hole and differing the distances between the two ends of the through hole and the another two clock signal lines on both sides of the clock signal line corresponding to the through hole, the through hole is not offset to another clock signal line when the through hole is offset, and the overlapping area of the through hole and the corresponding clock signal line remains unchanged, so that the impedance of the clock signal line changes little or even does not change, and the difference in impedance change of any two clock signal lines is slight or even the same, so as to avoid the impedance difference of different clock signal lines causing poor display.

Specifically, as illustrated in (b) of FIG. 9, (c) of FIG. 9, (d) of FIG. 9, and (e) of FIG. 9, the distance between the left end of the through holes 421 corresponding to the second clock signal line 312 and the first clock signal line 311 is not equal to the distance between the right end of the through hole 421 corresponding to the second clock signal line 312 and the third clock signal line 313.

Specifically, for the through hole with the clock signal lines on both sides, the through hole may be spaced apart from the clock signal lines on both sides; and for the through hole with the clock signal line on only one side, the through hole may be spaced apart from the clock signal lines on one side. The widths of two portions of the through hole beyond the corresponding clock signal line are not equal.

Specifically, the corresponding through holes above each clock signal line have the same length and the same width.

Specifically, as illustrated in FIG. 10, "-3" on the abscissa of (a) of FIG. 10 indicates that the through hole is offset to the left by 3 microns, and "3" on the abscissa of (a) of FIG. 10 indicates that the through hole is offset to the right by 3 microns. Similarly, other values and values in (b) of FIG. 10 may refer to the above description. (a) of FIG. 10 illustrates variations of the parasitic capacitance between each clock signal line and the low-potential signal line in FIG. 8 at different offsets. The abscissa in (a) of FIG. 10 represents the offset between the clock signal lines and the through holes of the low-potential signal line, and the ordinate represents the variation of the parasitic capacitance between the clock signal line and the low-potential signal line compared with the time when the clock signal lines and the through holes of the low-potential signal line are not offset. The bar graphs in FIG. 10 illustrate the variations of the parasitic capacitances between different clock signal lines and the low-potential signal lines. CK1-ANO represents the variation of the parasitic capacitance between the first clock signal line 311 and the low-potential signal line. CK2-ANO represents the variation of the parasitic capacitance between the second clock signal line 312 and the low-potential signal line. CK3-ANO represents the variation of the parasitic capacitance between the third clock signal line 313 and the low-potential signal line. CK4-ANO represents the variation of the parasitic capacitance between the fourth clock signal line 314 and the low-potential signal line. (b) of FIG. 10 shows variations of a parasitic capacitance between each clock signal line and all signal lines at different offsets. The abscissa in (b) of FIG. 10 represents the offset between the clock signal lines and the through holes of the low-potential signal line, and the ordinate represents the variation of the parasitic capacitance between the clock signal line and all signal lines compared with the time when the clock signal lines and the through holes of the low-potential signal line are not offset. The bar graphs in FIG. 10 illustrate the variations of the parasitic capacitances between different clock signal lines and all signal lines. CK1-Total represents the variation of the parasitic capacitance between the first clock signal line and all signal lines, CK2-Total represents the variation of the parasitic capacitance between the second clock signal line and all signal lines, CK3-Total represents the variation of the parasitic capacitance between the third clock signal line and all signal lines, and CK4-Total represents the variation of the parasitic capacitance between the fourth clock signal line and all signal lines.

By comparing FIG. 3 and FIG. 10, it can be seen that compared with the display device in the related art, in the display panels provided by the present application, as the offset of the through hole changes, the parasitic capacitance between each clock signal line and the low-potential signal line, as well as the variation of the parasitic capacitance between each clock signal line and all signal lines, is greatly reduced. For example, in FIG. 3, the variation of the parasitic capacitance between each clock line and the low-potential power signal line reaches 3.3%, and the variation of the parasitic capacitance between each clock line and all signal lines reaches 2.7%; in FIG. 10, the variation of the parasitic capacitance between each clock signal line and the low-potential signal line is less than 0.9%, and the variation of the parasitic capacitance between each clock signal line and all signal lines is less than 0.3%. That is, the variation of the parasitic capacitance of each clock signal line in the present application becomes smaller, the parasitic capacitance of the clock signal line is relatively stable, and the changing trend of some clock signal lines is the same, so that the parasitic capacitance of each clock signal line is similar or even equal, thereby avoiding different signal delays of adjacent clock signal lines, avoiding changes in signal delay caused by impedance changes of the clock signal lines, and allowing the display panel to display normally.

In some embodiments, as illustrated in FIG. 11, the through holes 421 include first through holes 421a corresponding to two adjacent clock signal lines 41 and second through holes 421b corresponding to one clock signal line 41. In the first direction, for two adjacent columns of through holes 421, ends of the through holes 421 in one column adjacent the other column are arranged in a straight line with ends of the through holes 421 in the other column. By aligning an end of the second through hole with an end of the first through hole and making the width of the portion of the second through hole beyond the clock signal line greater than the maximum offset of the through hole, the overlapping area of the clock signal line and the through holes will not change, so that the impedance of the clock signal line changes little or even does not change, and the difference in impedance change of any two clock signal lines is slight or even the same, so as to avoid the impedance difference of different clock signal lines causing poor display.

In some embodiments, as illustrated in FIG. 11, the first through hole 421a is arranged symmetrically with respect to a center line of a portion of the low-potential signal line 42 located between two adjacent clock signal lines 41, and the width (such as L5 in FIG. 11) of the portion of the second through hole 421b beyond the clock signal line 41 is greater than the maximum offset of the through holes 421. By arranging the first through hole symmetrically with respect to the center line of the portion of the low potential signal line between two adjacent clock signal lines, aligning one end of the second through hole with one end of the first through hole, and making the width of the portion of the second through hole beyond the clock signal line greater than the maximum offset of the through hole, the overlapping area of the clock signal line and the through holes will not change, so that the impedance of the clock signal line changes little or even does not change, and the difference in impedance change of any two clock signal lines is slight or even the same, so as to avoid the impedance difference of different clock signal lines causing poor display.

Specifically, the relative position of the through holes and the clock signal lines in the display panel illustrated in FIG. 11 is the relative position of the through holes and the clock signal lines when the through holes are in the non-offset state or in theoretical design position. It can be seen from FIG. 11 that even if the position of the through holes are offset during the actual preparation process, the overlapping areas of the through holes and the clock signal lines will not change, so that and the overlapping area of each clock signal line and the through holes will not change. As a result, the impedance of the clock signal line changes little or even does not change, and the difference in impedance change of any two clock signal lines is slight or even the same, so as to avoid the impedance difference of different clock signal lines causing poor display.

Specifically, (a) of FIG. 11 is a second laminated diagram of the clock signal line 41 and the low-potential signal line 42, (b) of FIG. 11 is an exploded view of the low-potential signal line 42 in (a) of FIG. 11, and (c) of FIG. 11 is an exploded view of the clock signal line 41 in (a) of FIG. 11.

Specifically, it can be understood that the diagrams in FIG. 11 and FIG. 12 may be designs in different display panels during the actual preparation process.

Specifically, as illustrated in FIG. 11, it can be seen that some of the through holes 421 are located above two clock signal lines 41, and some of the through holes 421 are located above one clock signal line 41.

In some embodiments, as illustrated in FIG. 11, an end of the through hole 421 corresponding to one clock signal lines 41 and the other end of the through hole 421 corresponding to the other clock signal line 41 are respectively located on center lines of the two clock signal lines 41. When two adjacent columns of through holes are offset, the increased overlapping area of one column of through holes and the clock signal line is equal to the reduced overlapping area of the other column of through holes and the clock signal line, thereby making the overlapping area of the clock signal line and the through holes does not change, so that the impedance of the clock signal line changes little or even does not change, and the difference in impedance change of any two clock signal lines is slight or even the same, so as to avoid the impedance difference of different clock signal lines causing poor display.

Specifically, when the through holes 421 are in the non-offset state, when two adjacent columns of through holes are offset, the increased overlapping area of the through holes in one column and the clock signal line is equal to the reduced overlapping area of the through holes in the other column and the clock signal line, so that the overlapping area of the clock signal line and the through holes does not change, so that the impedance of the clock signal line changes little or even does not change, and the difference in impedance change of any two clock signal lines is slight or even the same, so as to avoid the impedance difference of different clock signal lines causing poor display.

Specifically, two ends of the first through hole are respectively located on the center lines of two clock signal lines, and one end of the second through hole is located on the center line of one clock signal line.

Specifically, as illustrated in FIG. 11, the left end of the first through hole 421a is located on the center line of the first clock signal line 311, and the right end of the first through hole 421a is located on the center line of the second signal line 312.

In some embodiments, as illustrated in FIG. 12, for the first through holes 421a and the second through holes 421b corresponding to the same clock signal line 41, an overlapping area of one second through hole 421b and the corresponding clock signal line 41 is less than an overlapping area of one first through hole 421a and the corresponding clock signal line 41, an overlapping area of another second through hole 421b and the corresponding clock signal line 41 is greater than an overlapping area of another first through hole 421a and the corresponding clock signal line 41, and any first through hole 421a has different areas overlapping the corresponding two adjacent clock signal lines 41. When the through holes are offset, by reducing the overlapping area of one second through hole and the clock signal line, the overlapping area of the corresponding first through hole and the clock signal line is increased, and by increasing the overlapping area of one second through hole and the clock signal line, the overlapping area of the corresponding first through hole and the clock signal line decreases, so that the overlapping area of each clock signal line and the through holes does not change when the through holes are offset, the impedance of the clock signal line changes little or even does not change, and the difference in impedance change of any two clock signal lines is slight or even the same, so as to avoid the impedance difference of different clock signal lines causing poor display.

Specifically, when the through holes 421 are in the offset state, the offset of the through holes corresponding to any two clock signal lines are equalized, so that the overlapping area of each clock signal line and the corresponding through holes remains unchanged.

Specifically, as illustrated in FIG. 11, the display panel also includes a low-voltage signal line 44 and a start signal line 43. Since the low-voltage signal line 44 transmits a DC signal, the overlapping of the low-voltage signal line 44 and the through holes will not affect the signal on the low-voltage signal line 44. For the starting signal line 43, the overlapping of the through holes and the starting signal line 43 will lower the impedance of the starting signal line and reduce signal loss.

Specifically, taking the maximum offset of the through hole as 3 microns as an example, (a) of FIG. 12 illustrates an laminated diagram of the clock signal line and the low-potential signal line when the through holes in FIG. 11 are offset by 3 microns to the left relative to the clock signal line, (b) of FIG. 12 illustrates an laminated diagram of the clock signal line and the low-potential signal line when the through holes in FIG. 11 are offset by 2 microns to the left relative to the clock signal line, c) of FIG. 12 illustrates an laminated diagram of the clock signal line and the low-potential signal line when the through holes in FIG. 11 are offset by 1 micron to the left relative to the clock signal line, (d) of FIG. 12 illustrates an laminated diagram of the clock signal line and the low-potential signal line when the through holes in FIG. 11 are offset by 1 micron to the right relative to the clock signal line, (e) of FIG. 12 illustrates an laminated diagram of the clock signal line and the low-potential signal line when the through holes in FIG. 11 are offset by 2 microns to the right relative to the clock signal line, and (f) of FIG. 12 illustrates an laminated diagram of the clock signal line and the low-potential signal line when the through holes in FIG. 11 are offset by 3 microns to the right relative to the clock signal line.

As illustrated in FIG. 11, (a) of FIG. 12, (b) of FIG. 12, and (c) of FIG. 12, when the through holes 421 are offset to the left, the overlapping area of the first clock signal line 311 and the corresponding second through holes 421b is less than the overlapping area of the first clock signal line 311 and the corresponding first through holes 421a, and the overlapping area of the fourth clock signal line 314 and the corresponding second through holes 421b is greater than the overlapping area of the fourth clock signal line 314 and the corresponding first through holes 421a. As illustrated in FIG. 11, (d) of FIG. 12, (e) of FIG. 12, and (f) of FIG. 12, when the through holes 421 are offset to the right, the overlapping area of the first clock signal line and the corresponding second through holes 421b is greater than the overlapping area of the first clock signal line 311 and the corresponding first through holes 421a, and the overlapping area of the fourth clock signal line 314 and the corresponding second through holes 421b is less than the overlapping area of the fourth clock signal line 314 and the corresponding first through holes 421a. Furthermore, in (a) to (f) of FIG. 12, the areas of any clock signal line 41 overlapping the corresponding two first through holes are different.

Specifically, when the through holes are offset, the offset directions of the first through holes and the second through holes are the same. The increased overlapping area of one second through hole and the clock signal line is equal to the reduced overlapping area of the corresponding first through hole and the clock signal line, the reduced overlapping area of one second through hole and the clock signal line is equal to the increased overlapping area of the corresponding first through hole and the clock signal line, and the reduced overlapping area of one first through hole and the clock signal line is equal to the increased overlapping area of the other first through hole and the clock signal line, so that the overlapping area of each clock signal line and the through holes does not change.

Specifically, as illustrated in FIG. 13, "-3" on the abscissa of (a) of FIG. 13 indicates that the through hole is offset to the left by 3 microns, and "3" on the abscissa of (a) of FIG. 13 indicates that the through hole is offset to the right by 3 microns. Similarly, other values and values in (b) of FIG. 13 may refer to the above description. (a) of FIG. 13 illustrates variations of the parasitic capacitance between each clock signal line and the low-potential signal line in FIG. 11 at different offsets. The abscissa in (a) of FIG. 13 represents the offset between the clock signal lines and the through holes of the low-potential signal line, and the ordinate represents the variation of the parasitic capacitance between the clock signal line and the low-potential signal line compared with the time when the clock signal lines and the through holes of the low-potential signal line are not offset. The bar graphs in FIG. 13 illustrate the variations of the parasitic capacitances between different clock signal lines and the low-potential signal lines. CK1-ANO represents the variation of the parasitic capacitance between the first clock signal line 311 and the low-potential signal line. CK2-ANO represents the variation of the parasitic capacitance between the second clock signal line 312 and the low-potential signal line. CK3-ANO represents the variation of the parasitic capacitance between the third clock signal line 313 and the low-potential signal line. CK4-ANO represents the variation of the parasitic capacitance between the fourth clock signal line 314 and the low-potential signal line. (b) of FIG. 13 shows variations of the parasitic capacitance between each clock signal line in FIG. 11 and all signal lines at different offsets. The abscissa in (b) of FIG. 13 represents the offset between the clock signal lines and the through holes of the low-potential signal line, and the ordinate represents the variation of the parasitic capacitance between the clock signal line and all signal lines compared with the time when the clock signal lines and the through holes of the low-potential signal line are not offset. The bar graphs in FIG. 13 illustrate the variations of the parasitic capacitances between different clock signal lines and all signal lines. CK1-Total represents the variation of the parasitic capacitance between the first clock signal line and all signal lines, CK2-Total represents the variation of the parasitic capacitance between the second clock signal line and all signal lines, CK3-Total represents the variation of the parasitic capacitance between the third clock signal line and all signal lines, and CK4-Total represents the variation of the parasitic capacitance between the fourth clock signal line and all signal lines.

By comparing FIG. 3 and FIG. 13, it can be seen that compared with the display device in the related art, in the display panels provided by the present application, as the offset of the through hole changes, the parasitic capacitance between each clock signal line and the low-potential signal line, as well as the variation of the parasitic capacitance between each clock signal line and all signal lines, is greatly reduced. For example, in FIG. 3, the variation of the parasitic capacitance between each clock line and the low-potential power signal line reaches 3.3%, and the variation of the parasitic capacitance between each clock line and all signal lines reaches 2.7%; in FIG. 13, the variation of the parasitic capacitance between each clock signal line and the low-potential signal line is less than 0.3%, and the variation of the parasitic capacitance between each clock signal line and all signal lines is less than 0.1%. That is, the variation of the parasitic capacitance of each clock signal line in the present application becomes smaller, the parasitic capacitance of the clock signal line is relatively stable, and the changing trend of some clock signal lines is the same, so that the parasitic capacitance of each clock signal line is similar or even equal, thereby avoiding different signal delays of adjacent clock signal lines, avoiding changes in signal delay caused by impedance changes of the clock signal lines, and allowing the display panel to display normally.

In some embodiments, as illustrated in FIG. 5 to FIG. 11, the display panel 2 includes two groups of symmetrically arranged first scan driving units 31, and each group of first scan driving units 31 includes four clock signal lines 41.

In some embodiments, the through holes 421 include two columns of second through holes 421b and three columns of first through holes 421a, and the three columns of first through holes 421a are located between the two columns of second through holes 421b.

Specifically, the width of the first through hole and the width of the second through hole may be unequal, and the length of the first through hole and the length of the second through hole are equal.

Specifically, when the through holes are in the non-offset state, the second through holes 421b may not overlap with the low voltage signal line 44, and/or the second through holes 421b may not overlap with the starting signal line 43; or the second through holes 421b may not overlap with the low voltage signal line, and the second through holes 421b may overlap with the starting signal line 43; or the second through holes 421b may overlap with the low voltage signal line, and the second through holes 421b may not overlap with the starting signal line 43.

Specifically, in the above embodiments, the area, length, and width of each through hole are equal for description. However, the embodiments of the present application are not limited to this. It only needs to make that the overlapping area of any clock signal line and the corresponding through holes remains unchanged and the overlapping areas of any two clock signal lines and the through holes are equal.

In some embodiments, as illustrated in FIG. 6, the display panel 2 includes: a substrate 501, a light shielding layer 502, a buffer layer 503, a barrier layer 504, a first active layer 50, a first gate insulation layer 506, a first metal layer 507, a second gate insulation layer 508, a second metal layer 509, a first interlayer insulation layer 510, a second active layer 511, a third gate insulation layer 512, a third metal layer 513, a second interlayer insulation layer 514, a first source and drain layer 515, a first planarization layer 516, a second source and drain layer 517, a second planarization layer 518, a third source and drain layer 519, a third planarization layer 520, a pixel electrode layer 521, and a pixel definition layer 522. The first active layer 505 is provided on a side of the substrate 501. The first gate insulation layer 506 is disposed on a side of the first active layer 505. The first metal layer 507 is disposed on a side of the first gate insulation layer 506 away from the first active layer 505. The second gate insulation layer 508 is disposed on a side of the first metal layer 507 away from the first gate insulation layer 506. The second metal layer 509 is disposed on a side of the second gate insulation layer 508 away from the first metal layer 507. The first interlayer insulation layer 510 is disposed on a side of the second metal layer 509 away from the second gate insulation layer 508. The second active layer 511 is disposed on a side of the first interlayer insulation layer 510 away from the second metal layer 509. The third gate insulation layer 512 is disposed on a side of the second active layer 511 away from the first interlayer insulation layer 510. The third metal layer 513 is disposed on a side of the third gate insulation layer 512 away from the second active layer 511. The second interlayer insulation layer 514 is disposed on a side of the third metal layer 513 away from the third gate insulation layer 512. The first source and drain layer 515 is disposed on a side of the second interlayer insulation layer 514 away from the third metal layer 513. The first planarization layer 516 is disposed on a side of the first source and drain layer 515 away from the second interlayer insulation layer 514. The second source and drain layer 517 is disposed on a side of the first planarization layer 516 away from the first source and drain layer 515. The second planarization layer 518 is disposed on a side of the second source and drain layer 517 away from the first planarization layer 516. The third source and drain layer 519 is disposed on a side of the second planarization layer 518 away from the second source and drain layer 517. The third planarization layer 520 is disposed on a side of the third source and drain layer 519 away from the second planarization layer 518. The pixel electrode layer 521 is disposed on a side of the third planarization layer 520 away from the third source and drain layer 519. The pixel definition layer 522 is disposed on a side of the pixel electrode layer 521 away from the third planarization layer 520.

Specifically, the substrate 501 is configured to support each layer provided on the substrate 501. When the display panel 2 is a bottom-emission light-emitting display device or a double-side emission light-emitting display device, a transparent substrate is adopted. When the display panel 2 is a top-emission light-emitting display device, a translucent or opaque substrate as well as a transparent substrate may be adopted.

Specifically, the substrate 501 is used to support each film layer provided on the substrate 501. The substrate 501 may be made of an insulation material such as glass, quartz, or polymer resin. The substrate 501 may be a rigid substrate or a flexible substrate that can be bent, folded, rolled, etc. Examples of flexible materials for flexible substrates include, but are not limited to, polyimide (PI).

Specifically, the substrate 501 may include a first flexible substrate, a first barrier layer, a second flexible substrate, and a second barrier layer those are stacked. The first flexible substrate and the second flexible substrate may be made of the same material, such as polyimide. The first barrier layer and the second barrier layer may be made of, for example, an inorganic material including at least one of SiOx and SiNx.

Specifically, the thin film transistors in the display panel may be etching barrier type or back channel etching type; or may be divided into bottom gate thin film transistors, top gate thin film transistors, and other structures according to the positions of the gate electrodes and the active layers; or may be a divided into N-type thin film transistors and P-type thin film transistors according to the performances of the thin film transistors.

Specifically, the above embodiments illustrate the display panels in the embodiments of the present application from different aspects. When there is no conflict between the embodiments, the embodiments can be combined to achieve better technical effects.

At the same time, embodiments of the present application provide a display device, which includes the display panel as described in any of the above embodiments. The display device may be a mobile phone, a tablet, a TV, a monitor, a laptop, a digital photo frame, a navigator, and any other products or components with display function.

According to the above embodiments, it can be known that:
Embodiments of the present application provide display panels and display devices. The display panel includes a display area and a driving circuit area disposed on at least one side of the display area. The display panel includes a plurality of clock signal lines and a low-potential signal line. The clock signal lines are provided in the driving circuit area, and each of the clock signal lines extends along the first direction. The low-potential signal line is arranged in the driving circuit area. The orthographic projection of the plurality of clock signal lines on the low-potential signal line is located within the low-potential signal line. The low-potential signal line is provided with a plurality of through holes, and the through holes are arranged in an array to form a plurality of repeating units. In the repeating unit, the number of the through holes in each column is the same. For any two clock signal lines, the overlapping area of one clock signal line and all corresponding through holes in one repeating unit is equal to the overlapping area of the other one clock signal line and all corresponding through holes in one repeating unit, and the overlapping area of any clock signal line and all corresponding through holes in one repeating unit is equal to the product of the width of the clock signal line in the second direction, the length of the through hole in the first direction, and the number of through holes in one column in one repeating unit. The angle between the first direction and the second direction is greater than 0 and less than or equal to 90 degrees. In the present application, for any two clock signal lines, the overlapping area of one clock signal line 41 and the all corresponding through holes in one repeating unit is equal to the overlapping area of the other one clock signal line and the all corresponding through holes in one repeating unit are equal, and the overlapping area of any clock signal line and the corresponding through holes in one repeating unit is equal to the product of the width of the clock signal line in the second direction, the width of the through hole, and the number of the through holes in one column in one repeating unit, so that when positions of the through holes are offset, the overlapping area of any clock signal line and the through holes remains unchanged, and the overlapping area of each clock signal line and the through holes is equal, so that the parasitic capacitance of each clock signal line is similar or even equal, thereby avoiding different signal delays of adjacent clock signal lines, and preventing signal delay changes caused by impedance changes of the clock signal lines, so that the display panel may display normally.

In the above embodiments, each embodiment is described with its own emphasis. For parts that are not described in detail in a certain embodiment, please refer to the relevant descriptions of other embodiments.

The above is a detailed introduction to the display panels and the display devices provided by the embodiments of the present application. Specific examples are used in this paper to illustrate the principles and implementation methods of the present application. The description of the above embodiments is only used to help understand technical solutions and core ideas of the present application. Those of ordinary skill in the art should understand: it is still possible to modify the technical solutions recorded in the foregoing embodiments, or to equivalently replace some of the technical features; however, these modifications or substitutions do not cause the essence of the corresponding technical solutions to depart from the scope of the technical solutions of the embodiments of the present application.

## Claims

1. A display panel, comprising a display area and a driving circuit area disposed on at least one side of the display area, and comprising:
a plurality of clock signal lines, disposed in the driving circuit area and each extending along a first direction; and
a low-potential signal line, disposed in the driving circuit area, wherein an orthographic projection of the plurality of the clock signal lines on the low-potential signal line is located within the low-potential signal line;
wherein the low-potential signal line is provided with a plurality of through holes arranged in an array to define a plurality of repeating units; in each of the repeating units, a number of the through holes in each column is the same; for any two of the clock signal lines, an overlapping area of one of the clock signal lines and all corresponding ones of the through holes in one of the repeating units is equal to an overlapping area of the other one of the clock signal lines and all corresponding ones of the through holes in one of the repeating units, and an overlapping area of any one of the clock signal lines and corresponding ones of the through holes in one of the repeating units is equal to a product of a width of one of the clock signal lines in a second direction, a length of one of the through holes in the first direction, and a number of the through holes in one column in one of the repeating units; and an angle between the first direction and the second direction is greater than 0 and less than or equal to 90 degrees.

2. The display panel according to claim 1, wherein the through holes in each column are arranged along the first direction, and the through holes in adjacent two rows are spaced in the first direction.

3. The display panel according to claim 1, wherein a number of columns of the through holes is equal to a number of the clock signal lines, each column of through holes is arranged corresponding to one of the clock signal lines, each of the through holes is arranged symmetrically about a center axis of a corresponding one of the clock signal lines, a distance between an end of each of the through holes corresponding to one of the clock signal lines close to another one of the clock signal lines and the another one of the clock signal lines is greater than or equal to a maximum offset of the through holes, and a width of a portion of each of the through holes beyond the corresponding one of the clock signal lines is greater than or equal to the maximum offset of the through holes.

4. The display panel according to claim 3, wherein a width of each of the through holes is equal to a sum of a width of one of the clock signal lines and a distance between adjacent ones of the clock signal lines.

5. The display panel according to claim 3, wherein a distance between adjacent ones of the clock signal lines is greater than a sum of the maximum offset of the through holes and half of the width of the portion of each of the through holes beyond the corresponding one of the clock signal lines.

6. The display panel according to claim 1, wherein each column of through holes is arranged corresponding to one of the clock signal lines; in each of the repeating units, minimum distances of two ends of each of the through holes from a corresponding one of the clock signal lines are different; for any two of the clock signal lines, a minimum distance between one end of each of the through holes and the corresponding one of the clock signal lines is equal, and a minimum distance between the other end of each of the through holes and the corresponding one of the clock signal lines is equal.

7. The display panel according to claim 6, wherein each column of through holes is arranged corresponding to one of the clock signal lines; and for the through holes corresponding to one of the clock signal lines, one end of each is aligned with an end of the one of the clock signal lines, and the other end of each is aligned with another one of the clock signal lines.

8. The display panel according to claim 6, wherein a minimum distance between a left end of each of the through holes and the corresponding one of the clock signal lines is greater than a minimum distance between a right end of each of the through holes and the corresponding one of the clock signal lines; alternatively, the minimum distance between the left end of each of the through holes and the corresponding one of the clock signal lines is less than the minimum distance between the right end of each of the through holes and the corresponding one of the clock signal lines.

9. The display panel according to claim 1, wherein the through holes comprise first through holes each corresponding to two adjacent ones of the clock signal lines and second through holes each corresponding to one of the clock signal lines; along the first direction, for two adjacent columns of the through holes, one end of each of the through holes in one column close to the other column is located on a same straight line as one end of each of the through holes in the other column.

10. The display panel according to claim 9, wherein each of the first through holes is disposed symmetrically about a center line of a portion of the low potential signal line between two adjacent ones of the clock signal lines, and a width of a portion of each of the second through holes beyond the corresponding one of the clock signal lines is greater than the maximum offset of the through holes.

11. The display panel according to claim 10, wherein one end of each of the through holes corresponding to one of the clock signal lines and the other end of each of the through holes corresponding to another one of the clock signal lines are respectively located on center lines of the two ones of the the clock signal lines.

12. The display panel according to claim 9, wherein for the first through holes and the second through holes corresponding to a same one of the clock signal lines, an overlapping area of one of the second through holes and the corresponding one of the clock signal lines is less than an overlapping area of one of the first through holes and the corresponding one of the clock signal lines, an overlapping area of another one of the second through holes and the corresponding one of the clock signal lines is greater than an overlapping area of another one of the first through holes and the corresponding one of the clock signal lines, and areas of any one of the first through holes overlapping two adjacent ones of the clock signal lines are different.

13. The display panel according to claim 9, wherein the display panel comprises two groups of symmetrically arranged first scan driving units, each group of first scan driving units comprises four clock signal lines, and the through holes comprise two columns of second through holes and three columns of first through holes located between the two columns of second through holes.

14. A display device, comprising a display panel, the display panel comprising a display area and a driving circuit area disposed on at least one side of the display area, and the display panel comprising:
a plurality of clock signal lines, disposed in the driving circuit area and each extending along a first direction; and
a low-potential signal line, disposed in the driving circuit area, wherein an orthographic projection of the plurality of the clock signal lines on the low-potential signal line is located within the low-potential signal line;
wherein the low-potential signal line is provided with a plurality of through holes arranged in an array to define a plurality of repeating units; in each of the repeating units, a number of the through holes in each column is the same; for any two of the clock signal lines, an overlapping area of one of the clock signal lines and all corresponding ones of the through holes in one of the repeating units is equal to an overlapping area of the other one of the clock signal lines and all corresponding ones of the through holes in one of the repeating units, and an overlapping area of any one of the clock signal lines and corresponding ones of the through holes in one of the repeating units is equal to a product of a width of one of the clock signal lines in a second direction, a length of one of the through holes in the first direction, and a number of the through holes in one column in one of the repeating units; and an angle between the first direction and the second direction is greater than 0 and less than or equal to 90 degrees.

15. The display device according to claim 14, wherein the through holes in each column are arranged along the first direction, and the through holes in adjacent two rows are spaced in the first direction.

16. The display device according to claim 14, wherein a number of columns of the through holes is equal to a number of the clock signal lines, each column of through holes is arranged corresponding to one of the clock signal lines, each of the through holes is arranged symmetrically about a center axis of a corresponding one of the clock signal lines, a distance between an end of each of the through holes corresponding to one of the clock signal lines close to another one of the clock signal lines and the another one of the clock signal lines is greater than or equal to a maximum offset of the through holes, and a width of a portion of each of the through holes beyond the corresponding one of the clock signal lines is greater than or equal to the maximum offset of the through holes.

17. The display device according to claim 16, wherein a width of each of the through holes is equal to a sum of a width of one of the clock signal lines and a distance between adjacent ones of the clock signal lines.

18. The display device according to claim 16, wherein a distance between adjacent ones of the clock signal lines is greater than a sum of the maximum offset of the through holes and half of the width of the portion of each of the through holes beyond the corresponding one of the clock signal lines.

19. The display device according to claim 14, wherein each column of through holes is arranged corresponding to one of the clock signal lines; in each of the repeating units, minimum distances of two ends of each of the through holes from a corresponding one of the clock signal lines are different; for any two of the clock signal lines, a minimum distance between one end of each of the through holes and the corresponding one of the clock signal lines is equal, and a minimum distance between the other end of each of the through holes and the corresponding one of the clock signal lines is equal.

20. The display device according to claim 19, wherein each column of through holes is arranged corresponding to one of the clock signal lines; and for the through holes corresponding to one of the clock signal lines, one end of each is aligned with an end of the one of the clock signal lines, and the other end of each is aligned with another one of the clock signal lines.
